# EUROPÄISCHE PATENTSCHRIFT

(11) **EP 1 952 436 B1**
(45) Veröffentlichungstag und Bekanntmachung des Hinweises auf die Patenterteilung: **18.01.2012**
(21) Anmeldenummer: 06818560.2
(22) Anmeldetag: 15.11.2006
(51) Int. Cl.: H01L 21/683, H02N 13/00

(54) **BIPOLARER TRÄGERWAFER UND MOBILE, BIPOLARE, ELEKTROSTATISCHE WAFERANORDNUNG**
BIPOLAR CARRIER WAFER AND MOBILE BIPOLAR ELECTROSTATIC WAFER ARRANGEMENT
PLAQUETTE DE SUPPORT BIPOLAIRE ET DISPOSITIF DE PLAQUETTES MOBILE BIPOLAIRE ÉLECTROSTATIQUE

(30) Priorität: 25.11.2005 DE 102005056364
(43) Veröffentlichungstag der Anmeldung: 06.08.2008
(73) Patentinhaber: Fraunhofer-Gesellschaft zur Förderung der angewandten Forschung e.V., 80686 München (DE)
(72) Erfinder: WIELAND, Robert, 81241 München (DE); BOLLMANN, Dieter, 81475 München (DE)
(74) Vertreter: Pfenning, Meinig & Partner GbR
(86) Internationale Anmeldenummer: PCT/EP2006/010963
(87) Internationale Veröffentlichungsnummer: WO 2007/059887

(56) Entgegenhaltungen:
- EP-A- 1 513 191
- EP-A2- 1 220 311
- WO-A-2006/052576
- US-A1- 2004 173 161

## Beschreibung

Die vorliegende Erfindung bezieht sich im Bereich der Halbleitertechnik auf die Handhabungstechnik von Halbleiterwafern, insbesondere von dünnen Halbleiterwafern.

Dünne Halbleiterbauelemente haben seit einigen Jahren eine weite Verbreitung in der Welt der Mikroelektronik gefunden. Bekanntestes Beispiel hierfür sind integrierte Schaltkreise für Chipkarten, bei denen die Dicke der Silizium-Bauelemente heute etwa 150 µm beträgt. Auch bei der Herstellung von Solarzellen werden immer dünnere Wafer benutzt, um Material einzusparen. Darüber hinaus stellen die Leistungshalbleiter mit Chipdicken von ca. 100 µm ein wichtiges Marktsegment dar.

Eine weitere Reduzierung der Chipdicke auf unter 50 µm bietet mehrere große Vorteile:

Zum einen können sehr flache Gehäuseformen realisiert werden, wie es für tragbare elektronische Geräte (Handy, Fotoapparat, Notebook) notwendig ist. Auch bei RFID-Tags (Hochfrequenz Identifizierungs-Transponder) werden sehr dünne Chips ohne jedes Gehäuse eingesetzt.

Zweitens verbessert sich die Performance von Bauelementen, bei denen ein Stromfluss vertikal zur Chip-Rückseite erfolgt. Dies gilt in besonderem Maße für Leistungsbauelemente und Solarzellen.

Und drittens entstehen durch das Abdünnen der Schaltungswafer auf Dicken unter 30 µm mechanisch flexible Silizium-Chips, die sich hervorragend für kostengünstige Montageprozesse auf flexiblen Substraten eignen.

Auch die noch in Entwicklung befindliche, vertikale Integration von zu stapelnden Chips respektive Wafer mit dem Ziel, vertikale elektrische Verbindungen als direkte Durchkontaktierung durch gedünnte Siliziumsubstrate zu realisieren, benötigt ultradünne Wafer bzw. ultradünne Chips im Dickenbereich von typisch 10 bis 30 µm Siliziumdicke.

Diese Anwendungen sind nicht auf Silizium beschränkt, sondern können auch auf andere Halbleitermaterialien, wie Silizium-Germanium, Galliumarsenid, Siliziumcarbid, III-V Halbleiter wie AlGaAsP für die Optoelektronik oder pyroelektrische Stoffe wie LiNbO₃ für die Telekommunikation übertragen werden. Bei diesen Materialien ist eine neue Handhabungstechnik noch dringender gesucht, weil die ultradünnen Wafer mit diesen Materialien deutlich bruchgefährdeter, teurer und schwieriger zu bearbeiten sind, als Silizium. Ultradünne Wafer im Sinne dieser Erfindung sind Wafer aus einkristallinem, polykristallinem oder amorphem Halbleiterwerkstoff, welche so dünn sind, dass sie in normalen Bearbeitungsgeräten ein wirtschaftlich nicht tragbares Bruchrisiko darstellen.

Die Dicke unterschreitet dabei üblicherweise 1/10 mm. Wirtschaftlich besonders interessant sind Dicken von 50 bis 10 µm. Jedoch sollte damit auch die Handhabung von Schichten von wenigen µm (≤ 10 µm) möglich sein. Diese Trägertechnik kann auch auf isolierende Materialien wie ultradünne Glasscheiben, Quarz, Saphir und ähnliche angewendet werden.

Ohne geeignete Unterstützung durch eine Trägertechnik neigen diese ultradünnen Wafer dazu, sich durch innere Spannungen spontan aufzurollen.

Um diese ultradünnen Halbleiter bearbeiten zu können, ist es von grundlegender Bedeutung eine geeignete Handhabungstechnik zu entwickeln. Einkristallines Silizium ist ein sprödes Material, das bei geringen,mechanischen Belastungen leicht bricht. Diese Gefahr des Waferbruchs stellt derzeit das größte technische Problem bei der Herstellung von ultradünnen Halbleitern dar. Zudem verlieren ultradünne Wafer ihre gewohnte Stabilität und biegen sich bereits durch ihr eigenes Gewicht und Massenträgheit um mehrere Millimeter durch. Damit sind normale Handler, welche die Wafer aus einer Horde entnehmen und diversen Bearbeitungsstationen zuführen, nicht mehr verwendbar. Auch die scharfkantigen Ränder der dünn geschliffenen Wafer führen zu Problemen beim Transport. Das häufige Nachjustieren der Handler auf die jeweilige Verformung der Wafer bei der jeweiligen Dicke und Schichtaufbau ist unwirtschaftlich und fehlerträchtig.

Bekannt aus dem Stand der Technik ist die Handhabung von dünnen Wafern durch Aufkleben auf eine Trägerplatte. Der wesentliche Schritt ist hierbei die Unterstützung des dünnen Nutzwafers durch einen normal dicken Trägerwafer. Die Verbindung der beiden Wafer erfolgt dabei durch Wachs, einen thermoplastischen Klebstoff oder eine beidseitig klebende Folie, die sich durch Temperatureinwirkung oder Bestrahlung mit UV-Licht wieder ablösen lässt. Für viele Bearbeitungsgeräte wie Grinder, Spinätzer oder Messgeräte wird diese Folie erfolgreich angewendet. Jedoch kann, wenn bei Plasmaanlagen, Ofen oder Schichtabscheidungen die Bearbeitungstemperatur höher als etwa 150°C wird, die Folie zerstört werden und ihre Klebefunktion verlieren. Weil jeder Kleber empfindlich auf gewisse Chemikalien reagiert, kann diese Klebung in Bädern mit Lösungsmitteln, Säuren oder ähnlichem nicht verwendet werden. Nach erfolgter Bearbeitung und Ablösung des Nutzwafers bzw. des zu prozessierenden Wafers werden manchmal Rückstände der Klebeschicht auf der Oberfläche des Nutzwafers beobachtet, was zur unerlaubten Kontamination der Anlagen führt.

In den Druckschriften DE 102 38 601 A1 und DE 102 32 914 A1 wird ein perforierter Trägerwafer beschrieben, der mit einem anfangs flüssigen Kleber arbeitet. Nach der Bearbeitung wird der Nutzwafer durch ein Lösungsmittel, das durch die Poren des Trägerwafers dringt, abgelöst. Auch hier treten die erwähnten Probleme der begrenzten Temperaturverträglichkeit, der begrenzten Beständigkeit gegen Chemikalien und der möglichen Kontamination auf.

Von Carinthian Tech Research, Villach wurde ein Bernoulli Vacuum Greifer entwickelt, der durch einen geschickt gestalteten Luftstrom zwischen Trägerwafer und Nutzwafer gemäß dem Prinzip von Bernoulli einen konstanten Luftspalt erzeugt. Damit kann ein dünner Wafer von einer Horde in eine Anlage und zurück transportiert werden. Jedoch ist dies nur in einer Umgebung mit atmosphärischem Druck möglich. In Anlagen mit Vakuum oder Unterdruck versagt diese Methode und der dünne Wafer muss auf andere Weise gehalten werden. Auch die laterale Fixierung und die Verdrehung des Nutzwafers sind problematisch.

In Plasmaanlagen ist darüber hinaus das Prinzip des elektrostatischen Chucks (E-Chucks) bekannt:

Nach dem Ablegen des zu bearbeitenden Wafers auf dem elektrostatischen Chuck wird in der Vakuumkammer des Reaktors zunächst nach dem Einregeln der Gasflüsse der gewünschte Kammerdruck eingestellt. Dann wird mit Hilfe eines meist hochfrequenten Wechselspannungsfeldes das Plasma gezündet und der entsprechende Ätzoder Depositionsschritt eingeleitet. Gleichzeitig wird über eine eigene Hochspannungsversorgung eine Gleichspannung zwischen der Anode des Reaktors und der Rückseite des elektrostatischen Chucks angelegt. Das daraus resultierende elektrische Feld zwischen der Waferrückseite und der Isolationsschicht des Chucks hält den Wafer fest und erlaubt u.a. eine rückseitige Kühlung des Wafers durch Anströmen kleiner Mengen von He-Gas. Üblicherweise besteht die Isolationsschicht eines elektrostatischen Chucks aus temperaturfesten Kunststoffen oder keramischen Materialien. Kühlkanäle auf der Chuckoberseite sorgen für entsprechende Wärmeableitung auf der Waferrückseite, um die Wafertemperatur möglichst konstant zu halten und die durch Plasmen eingebrachten Wärmemengen abzuleiten.

Damit könnte ein dünner Wafer genauso wie ein normal dicker Wafer gehalten und bearbeitet werden. Jedoch ist dieser erwähnte elektrostatische Chuck ein fester Bestandteil der Anlage. Vor und nach der Bearbeitung muss der Wafer durch einen Handler entnommen und transportiert werden. Das ist jedoch durch die oben beschriebenen Probleme der elastischen Durchbiegung und die Bruchgefahr bei ultradünnen Wafern nicht mehr möglich.

In dem japanischen Patent JP 59 132 139 A ist ein unipolarer elektrostatischer Chuck beschrieben. Hier wird eine permanente Haltekraft durch Anwendung von Hochspannung zwischen einer Platte und einem Wafer durch Polarisierung einer dielektrischen Schicht erzeugt. Auch nach Entfernen des Kabels wird die permanente Haltekraft aufrechterhalten. Es wird jedoch nichts über die Dimension dieser Anordnung oder die Mobilität und damit die Verwendbarkeit beim Transport oder in Bearbeitungsgeräten ausgesagt.

In WO 02/11184 A1 wird ein bipolarer mobiler Halter beschrieben, der einen Wafer durch elektrostatische Kraft auf einem Basiselement befestigt. Eine funktionale Schicht erhält hier einen elektrostatisch aktiven Zustand auch ohne äußere Spannungsversorgung. Hier werden jedoch zwei Elektroden auf der gleichen Seite des Halters beschrieben, welche von der Vorderseite im Bereich des Flats kontaktiert werden.

Elektrostatische Trägerwafer können auch aus keramischem Material hergestellt werden. Damit kann ein dünner Wafer in manchen Anlagen bearbeitet werden. Probleme bereitet jedoch der unterschiedliche Wärmeausdehnungskoeffizient von Silizium und Keramik. Der Trägerwafer kann sich im heißen Zustand erheblich verbiegen. Auch im Ruhezustand ist er nicht ausreichend eben. Die Erfahrung zeigt eine zeitlich begrenzte Haltekraft des keramischen Trägerwafers, was auf einen mit der Temperatur zunehmenden Leckstrom in der Keramik zurückzuführen ist. Für die Verantwortlichen eines Reinraumes sind auch die fremden und nicht exakt spezifizierten Materialien wie Keramik und Siebdruckpasten suspekt, da die Gefahr der Kontamination mit Metallen gegeben ist.

Auch elektrostatische Trägerwafer aus Kunststoff bieten keine zufrieden stellende Lösung, weil auch diese im Temperaturbereich beschränkt, gegen Lösemittel empfindlich, nicht ausreichend eben und eine mögliche Quelle von Kontamination sind.

Die EP 1 513 191 A2, die EP 1 220 311 A2 und die US 2004/0173161 A1 beschreiben jeweils einen Trägerwafer, welcher eine Trägerschicht, die elektrisch isolierend ist oder elektrisch isolierend beschichtet ist, auf der Vorder- und Rückseite aufgebrachte elektrisch leitende Schichtbereiche sowie eine die Anordnung umhüllende Isolationsschicht aufweist.

Die JP 10-12712 A offenbart einen Trägerwafer, welche ein metallisches Substrat aufweist, auf dessen Oberseite elektrisch leitende und elektrisch isolierende Schichten angeordnet sind. Die Schichten erstrecken sich über eine Durchgangsbohrung auf die Rückseite des Substrates und enden dort in einer Ausnehmung.

Das Dokument JP03194948 beschreibt ebenso einen Trägerwafer mit einer verbindenden elektrisch leitenden Auβenrandschicht.

Ziel der Entwicklung ist somit eine neue Handhabungstechnik, mit der die ultradünnen Wafer in allen üblichen Bearbeitungsgeräten ohne spezielle Anpassung, wie normale Wafer bearbeitet werden könnten. Nach der Bearbeitung sollte der Nutzwafer möglichst bequem und problemlos vom Trägerwafer zu lösen sein. Der Trägerwafer sollte dabei wiederverwendbar und kostengünstig herzustellen sein.

Ausgehend vom Stand der Technik ist es daher Aufgabe der vorliegenden Erfindung gemaβ dem Anspruch 1, einen Trägerwafer und eine Waferanordnung zur Verfügung zu stellen, mit denen dünne oder ultradünne Nutzwafer auf einfache, zuverlässige, auch Zerstörungen, insbesondere Bruchschäden, am Nutzwafer vermeidende Art und Weise handhabbar sind.

Diese Aufgabe wird durch den Trägerwafer nach Anspruch 1 gelöst. Vorteilhafte Weiterbildungen der erfindungsgemäßen Trägerwafer und Anordnungen werden in den jeweiligen abhängigen Ansprüchen gegeben. Weiterhin wird die erfindungsgemäße Aufgabe durch das elektrostatische Halteverfahren nach Anspruch 36 sowie in dessen vorteilhaften Ausführungsformen gemäß der hier zugehörigen abhängigen Ansprüche gelöst.

Erfindungsgemäß werden ultradünne Wafer bzw. auch einzelne Nutzchips, im folgenden zusammenfassend als flächige Bauelemente bezeichnet, mit Hilfe eines erfindungsgemäßen mobilen, elektrostatischen Trägerwafers gehalten. Die Bauelemente können damit in den Geräten der Halbleiterindustrie bearbeitet, transportiert und gelagert werden.

Erfindungsgemäß besteht die Trägerschicht (Substrat) des Trägerwafers aus einem elektrisch isolierenden Material oder ist durch eine die Trägerschicht vorzugsweise vollständig umgebende, elektrisch isolierende Hüllschicht bedeckt.

Hierauf ist eine elektrisch leitfähige Schicht aufgebracht, die in mindestens zwei elektrisch voneinander getrennten Bereichen strukturiert ist. Diese Strukturierung befindet sich vorzugsweise auf der Vorderseite des Trägerwafers, an der die elektronischen Bauelemente gehalten werden sollen. Die elektrische Schicht bildet so mindestens zwei Elektroden aus, an die eine Spannung angelegt werden kann. In dem so erzeugten elektrischen Feld auf der Vorderseite des Trägerwafers werden die elektronischen Bauelemente, beispielsweise Chips oder auch Nutzwafer, auf der Vorderseite des Trägerwafers gehalten.

Auf der Rückseite des Trägerwafers sind für jede der elektrisch isoliert voneinander vorhandenen Bereiche der Vorderseite jeweils mindestens ein elektrischer Kontakt vorgesehen. Die Kontaktierung der vorderseitigen Elektroden mit den rückseitigen elektrischen Kontakten erfolgt über einen leitenden Bereich, der sich von der Vorderseite des Trägerwafers über dessen Kante hinweg auf die Rückseite zu dem jeweiligen Kontakt erstreckt. Als Kante oder auch Außenkante wird die den Wafer nach außen begrenzende Fläche zwischen Vorder- und Rückseite bezeichnet. Die Kante begrenzt also den Gesamtdurchmesser des Wafers. Synonym zu Kante und Außenkante wird auch vom Rand gesprochen.

Abschließend ist auf der elektrisch leitenden Schicht den Trägerwafer umgebend eine weitere elektrisch isolierende (dielektrische) Hüllschicht aufgebracht. Diese bedeckt zumindest die Vorderseite des Trägerwafers sowie dessen Kante, während sie die rückseitigen elektrischen Kontakte zumindest bereichsweise nicht bedeckt, so dass dort Elektroden angeschlossen werden können. Dies wird beispielsweise dadurch erreicht, dass auf die elektrisch leitende strukturierte Schicht ein äußeres Dielektrikum aufgebracht wird, das auf der Rückseite teilweise freigeätzt wird, um die Rückseitenkontakte freizulegen.

Erfindungsgemäß wird nun ein elektrisches Bauelement auf der Vorderseite festgehalten, indem an die rückseitigen Kontakte eine Spannung angelegt wird. In dem bipolaren elektrostatischen Feld zwischen den vorderseitigen gegenpoligen Elektroden wird das Bauelement an der Vorderseite des Trägerwafers gehalten. Dieser Sandwich aus Trägerwafer und Bauelement, beispielsweise Nutzwafer, kann dann im Falle eines Nutzwafers als Bauelement wie ein normal dicker Wafer in den üblichen in der Branche verbreiteten Geräten verarbeitet, von Handlern transportiert und in Waferhorden gelagert werden. Dies ist insbesondere möglich, wenn die Dicke der Anordnung aus Trägerwafer und Bauelement und/oder der Durchmesser der Anordnung aus Trägerwafer und Bauelement die entsprechenden Maße eines handelsüblichen Wafers einhalten bzw. innerhalb deren Toleranzgrenzen liegen. Für die Dicken und den Durchmesser der Anordnung werden daher vorteilhafterweise die in der Halbleitertechnologie üblichen Toleranzen für Siliziumwafer gemäß SEMI-Standard M1-0302 und M1.1 bis M1.15 eingehalten. Neben einem Nutzwafer mit gleichem Durchmesser wie der Trägerwafer als Bauelement sind auch Nutzwafer verarbeitbar, die einen kleineren Durchmesser als der Trägerwafer aufweisen. Zum einen können diese geringfügig kleiner sein, wodurch Probleme mit der sehr scharfen Kante des ultradünnen Nutzwafers vermieden werden können. Es kann aber auch ein kleinerer exotischer Nutzwafer auf einem normal großen Trägerwafer transportiert werden, z.B. ein 3-Zoll-Germaniumwafer auf einem 6-Zoll-Siliziumwafer, um vorhandene Geräte zu benutzen.

Als Trägerschicht des Trägerwafers kann vorteilhafterweise übliches p- oder n-dotiertes, einkristallines Silizium verwendet werden. Dies eignet sich insbesondere, wenn für das zu haltende Bauelement Silizium, Germanium, Germaniumarsenid, Siliziumkarbid, Indiumphosphid, Indiumgalliumarsenphosphid verwendet wird. In diesem Falle besitzen Träger- und Nutzwafer eine ähnliche Wärmeausdehnung. In diesem Falle ist es erforderlich, die Trägerschicht durch eine elektrisch isolierende Schicht von den elektrisch leitenden Elektroden zu isolieren.

Alternativ können auch elektrisch isolierende Materialien, wie beispielsweise Siliziumdioxid oder Siliziumnitrid Si₃N₄ für die Trägerschicht verwendet werden. Es kann dann die unmittelbar auf diese Trägerschicht aufgebrachte elektrisch isolierende Schicht weggelassen werden.

Statt einer Trägerschicht aus elektrisch halbleitendem Material ist es auch möglich, eine Trägerschicht aus Metall zu verwenden. Es handelt sich in diesem Falle nicht um einen Wafer im eigentlichen Sinne, da dieser üblicherweise als dünne Scheibe aus Halbleitermaterial definiert ist, sondern um einen Trägerwafer in einem erweiterten Sinne, für den die Definition des Wafers mit Ausnahme des dazu verwendeten Materials weiterhin gültig ist.

Für die elektrisch isolierenden Schichten (zwischen der Trägerschicht und der elektrisch leitenden Schicht bzw. oberhalb der elektrisch leitenden Schicht) wird vorzugsweise Siliziumdioxid verwendet, vorteilhafterweise als thermisches Oxid. Es kann hier jedoch auch CVD-abgeschiedenes Siliziumdioxid oder auch ein Siliziumnitrid verwendet werden.

Für die Erzeugung der bipolaren Elektroden auf der Vorderseite des Trägerwafers wird zunächst ein leitfähiges oder dotierbares Material, wie beispielsweise polykristallines oder amorphes Silizium, vorteilhafterweise vollflächig oder auf Vorderseite, Kante und Rückseite des Trägerwafers, abgeschieden. Wird ein CVD-Prozess verwendet, so erfolgt die Abscheidung ohne weiteres Zutun allseitig, also auf Vorder- und Rückseite und am Rand, gleichzeitig.

Es können jedoch als elektrisch leitende Schicht auch Metalle oder andere Schichten, die eine elektrische Leitfähigkeit aufweisen, verwendet werden. Die folgenden Materialien eignen sich besonders als leitfähige Materialien für die elektrisch leitende Schicht: amorphes Silizium, Polysilizium (beides vorzugsweise mit P, B oder As dotiert), dotiertes Polysilizium, Titannitrid (TiN) abgeschieden über CVD-Verfahren, Titannitrid (TiN) abgeschieden durch Sputtern, Silizide (TaSi₂, WSi₂, MoSi₂, NiSi₂, CoSi₂ u. dgl.), Titan (Ti), vorteilhafterweise aufgesputtert, Wolfram (W), vorteilhafterweise abgeschieden über CVD-Verfahren, Molybdän (Mo), Aluminiumlegierungen (z.B. AlSi1%, Al-Si1%Cu0, 5%), Reinaluminium (Al), Gold (Au), Kupfer (Cu) und/oder Silber (Ag) und deren Mischungen und Legierungen.

Als nächstes wird dann die elektrisch leitende Schicht vorderseitig strukturiert, beispielsweise über lithographische Fototechniken (Kontaktbelichter oder Stepper) und einer nachfolgenden naß- oder trockenchemischen Ätzung (Plasmaätzen). Die erzeugten Strukturgrößen und Formen bestimmen dann später die Geometrie des elektrischen Feldes. Besonders vorteilhaft können die Elektroden in Form von Kreissektoren (Tortenstücke), ineinandergeschachtelte Kreisringe mit unterschiedlichen Radien oder lineare kammartige Fingeranordnungen (Interdigital-Kondensatoren) verwendet werden.

Die Unterteilung der Elektroden in Segmente oder Zonen wird also nur auf der Vorderseite vorgenommen. Zusätzlich werden zwei Stellen auf der Rückseite als Kontaktierungen von außen strukturiert. Um die rückseitige Kontaktierung der Elektroden kostengünstig zu gestalten, wird die elektrisch leitende Schicht um die Waferkante herumgeführt. Dies kann besonders einfach realisiert werden, wenn bei der Strukturierung der leitfähigen Schicht an den entsprechenden Stellen die Waferkante mit einem ätzresistenten Tape abgeklebt wird. Alternativ kann bei einem geeigneten Lithographieverfahren auf die sonst übliche Randentlackung an den entsprechenden Stellen, an denen die elektrische Schicht von der Vorderseite auf die Rückseite herumgeführt wird, verzichtet werden, so dass eine Leiterbahn um die Kante herum erzeugt werden kann. Als weitere Möglichkeit ist es möglich, eine derartige Kantenbeschichtung durch eine lokale selektive Abscheidung (beispielsweise Laser-Direktschreiben) zu erzeugen.

Nach erfolgter Strukturierung wird nun ein weiteres Dielektrikum, vorzugsweise wiederum Siliziumoxid, abgeschieden über CVD-Verfahren oder thermisch abgeschieden, oder auch Siliziumnitrid oder eine Kombination derartiger Materialien oder Schichten allseitig abgeschieden. Diese elektrisch isolierende Schicht kann auch mittels eines Materials erzeugt werden, das permanent elektrisch polarisierbar ist, wodurch die sichere Halterung des Bauelementes auf der Vorderseite des Trägerwafers über einen längeren Zeitraum garantiert werden kann.

Der rückseitige Kontakt wird nun hergestellt, indem die rückseitigen Kontaktflächen der elektrisch leitfähigen Schicht freigelegt, beispielsweise freigeätzt oder mechanisch freigelegt werden. Vorteilhafterweise kann auch die gesamte Rückseite unter Beachtung eines Randausschlusses lithographisch strukturiert und freigeätzt werden. Bei hochdotiertem Silizium als elektrisch leitfähiger Schicht besteht dann bereits ein ausreichend guter Ohmscher Kontakt.

Diese nunmehr strukturierte Isolationsschicht deckt damit dann wiederum die Vorderseite des Wafers, den Rand, und die Waferkante allseitig ab und ist nur an den Kontaktierungsstellen der Rückseite bzw. in deren Bereich geöffnet. Dadurch ist es dann möglich, den Trägerwafer jederzeit mittels zwei Kontakten, z.B. Messspitzen, von der Rückseite her aufzuladen bzw. nachzuladen.

Der erfindungsgemäße Trägerwafer wird nach dem Prinzip des bipolaren E-Chucks betrieben. Auf den Trägerwafer werden der zu bearbeitende dünne Wafer bzw. die zu bearbeitenden Chips aufgelegt. Die beiden Wafer bzw. Wafer und Chips können als parallel geschaltete einzelne Flächen eines Plattenkondensators betrachtet werden. Das elektrische Feld ist großteils vertikal zwischen Trägerwafer und Nutzwafer bzw. Nutzchips ausgerichtet. Die Aufladung der Plattenkondensatoren geschieht durch Auflegen des Trägerwafers auf eine entsprechende Hilfsvorrichtung und vorübergehendes Berühren des Trägerwafers von der Rückseite mit zwei Hochspannungselektroden. Dieses elektrische Feld übt eine haltende elektrostatische Kraft auf den Nutzwafer bzw. auf die einzelnen Chips aus. Die nutzbare Haltekraft steigt dabei an, je dünner das Dielektrikum ist. Erfahrungsgemäß hält der Nutzwafer umso sicherer, je dünner er ist. Die notwendige Spannung richtet sich nach der Dicke des Isolators und der notwendigen Feldstärke und damit der Haltekraft und liegt typischerweise bei 50 bis 500 V.

Die Kombination von Trägerwafer und dünnem Nutzwafer bzw. Nutzchips bildet nun eine untrennbare Einheit, die von einem Bearbeitungsgerät wie ein normaler Wafer bearbeitet werden kann. Sie kann auch von normalen Handlern und in Horden transportiert werden.

Nach oder während der Bearbeitung, dem Transport oder einer Lagerung kann bei Bedarf die Haltekraft durch ein Nachladen wieder aufgefrischt werden. Die Dauer des sicheren Haltens ergibt sich aus der Isolationseigenschaft des Dielektrikums und der umgebenden Luft bzw. der umgebenden Medien und reicht von etwa einer Stunde bis zu Tagen.

Am Ende der Bearbeitung werden der Nutzwafer bzw. die Nutzchips vom Trägerwafer durch ein einfaches Entladen getrennt. Die Erfahrung mit elektrostatischen Chucks zeigt, dass dabei manchmal ein vorübergehendes oder periodisches Umpolen notwendig sein kann, um getrappte Ladungen zu neutralisieren. Der Nutzwafer kann damit an einen Träger mit Klebe- oder Vakuumtechnik übergeben oder der Aufbau- und Verbindungstechnik zugeführt werden.

Im folgenden werden einige Beispiele erfindungsgemäßer Trägerwafer und Anordnungen gegeben. Es zeigen
- Figur 1: eine erfindungsgemäße Anordnung in einer seitlichen Schnittansicht;
- Figur 2: die Aufsicht auf die Vorderseite eines erfindungsgemäßen Trägerwafers;

- Figur 3: die Aufsicht auf die Vorderseite eines weiteren erfindungsgemäßen Trägerwafers; und
- Figur 4: die Rückseite eines Trägerwafers mit Kontaktflächen.

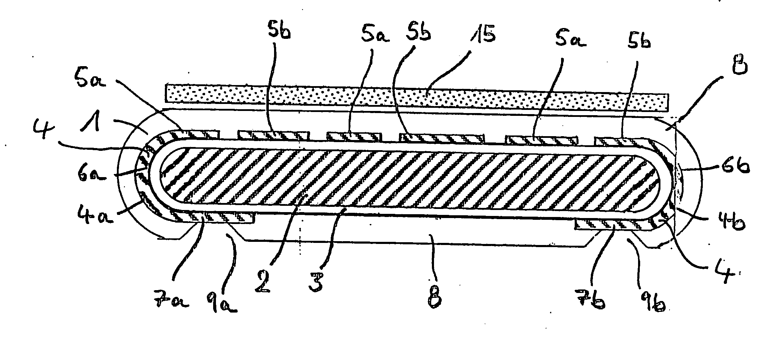

Figur 1 zeigt den Querschnitt durch eine Anordnung, wie sie in der vorliegenden Erfindung beschrieben ist. Dabei bezeichnen hier wie in den folgenden Figuren gleiche oder ähnliche Bezugszeichen gleiche oder ähnliche Elemente.

Die Anordnung ist aufgebaut aus einem Trägerwafer 1, auf dessen Vorderseite ein scheibenförmiges Halbleiterbauteil, hier ein ultradünner Nutzwafer 15, gehalten wird. Der Trägerwafer 1 besitzt eine Trägerschicht 2 aus einkristallinem Silizium, die allseitig von einer elektrisch isolierenden Schicht 3 aus Siliziumoxid SiO₂ umgeben ist. Auf dieser dielektrischen Schicht 3 ist eine elektrisch leitende Schicht 4 angeordnet, die in zwei voneinander elektrisch getrennte Bereiche 4a und 4b strukturiert ist. Die elektrisch leitenden Bereiche 4a bzw. 4b besitzen vorderseitige Bereiche 5a bzw. 5b, einen die Kante der Trägerschicht 2 umgebenden seitlichen Bereich 6a bzw. 6b und rückseitige Bereiche 7a bzw. 7b. Sämtliche Bereiche 4a, 5a, 6a und 7a sind elektrisch leitend miteinander verbunden, während sämtliche elektrischen Bereiche 4b, 5b, 6b und 7b ihrerseits elektrisch leitend miteinander verbunden sind. Untereinander sind diese beiden elektrisch leitenden Beschichtungen voneinander elektrisch isoliert. Die Vorderseitigen elektrischen Bereiche 5a bilden nun bei Anlegung einer passenden Spannung an den als rückseitigen Kontakt verwendeten Bereich 7a als Pluspol, während die vorderseitigen Bereiche 5b unter Anlegung einer negativen Spannung an den als elektrischen Kontakt wirkenden rückseitigen Bereich 7b als Minuspol zu betrachten sind. Die Kontaktierung zwischen dem rückseitigen Kontakt 7a bzw. 7b.und den vorderseitigen Elektroden 5a bzw. 5b erfolgt über die kantenumgreifenden Bereiche 6a bzw. 6b. Zwischen den vorderseitigen Elektroden 5a und 5b bilden sich nun elektrische Felder aus, die den Nutzwafer 15 sicher auf der Oberfläche des Trägerwafers 1 halten. Der Trägerwafer ist insgesamt mit einer weiteren elek-
trisch isolierenden Schicht 8 allseitig umgeben, so dass die elektrisch leitende Beschichtung 4a, 5a, 6a bzw. 4b, 5b, 6b elektrisch von dem Nutzwafer 15 getrennt sind. Lediglich die rückseitigen Kontaktbereiche 7a bzw. 7b werden von der elektrisch isolierenden Schicht 8, die wiederum aus Siliziumdioxid besteht, ausgespart, so dass es möglich ist, an diese Bereiche 7a und 7b durch die Öffnungen 9a und 9b in der elektrisch isolierenden Schicht 8 Spannungen anzulegen.

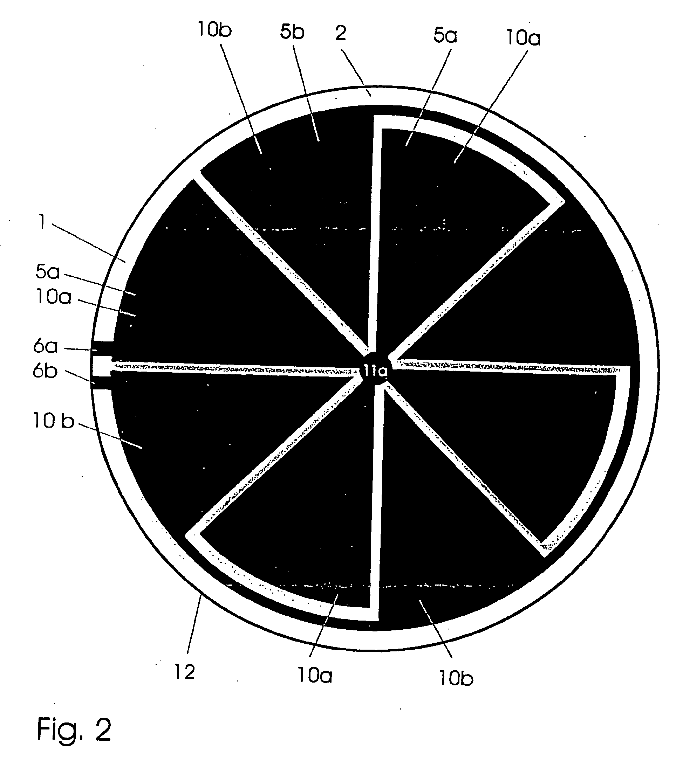

Figur 2 zeigt nun die Aufsicht auf die Vorderseite eines erfindungsgemäßen Trägerwafers. Dieser Trägerwafer besitzt vorderseitig eine strukturierte elektrisch leitende Beschichtung, deren Durchmesser etwas geringer ist als der Gesamtdurchmesser des Trägerwafers, der durch den Waferrand 12 gekennzeichnet ist. Die Beschichtung in die elektrisch voneinander getrennten Bereiche 5a und 5b ist segmentartig strukturiert, wobei die einzelnen Kreissegmente mit 10a bzw. 10b gekennzeichnet sind. Jeweils benachbarte Kreissegmente gehören zu verschiedenen Beschichtungsbereichen 5a oder 5b. Die zu der Beschichtung 5a gehörenden Kreissegmente 10a sind über einen gemeinsamen elektrisch leitenden Bereich 11a miteinander elektrisch leitend verbunden und über eine Leitungsbahn 6a, die über die Kante 12 des Trägerwafers 1 geführt ist, auf die Rückseite des Trägerwafers 1 durchkontaktiert.

Die zu dem elektrisch leitenden Bereich 5b gehörenden Kreissegmente 10b sind über elektrische Leiterbahnen 11b elektrisch leitend miteinander verbunden und über eine elektrische Leiterbahn 6b auf die Rückseite des Wafers 1 durchkontaktiert. Die Leiterbahn 6b ist über die Kante 12 des Trägerwafers 1 geführt.

Auf einem derart strukturierten Trägerwafer können besonders vorteilhaft ultradünne Nutzwafer gehalten werden.

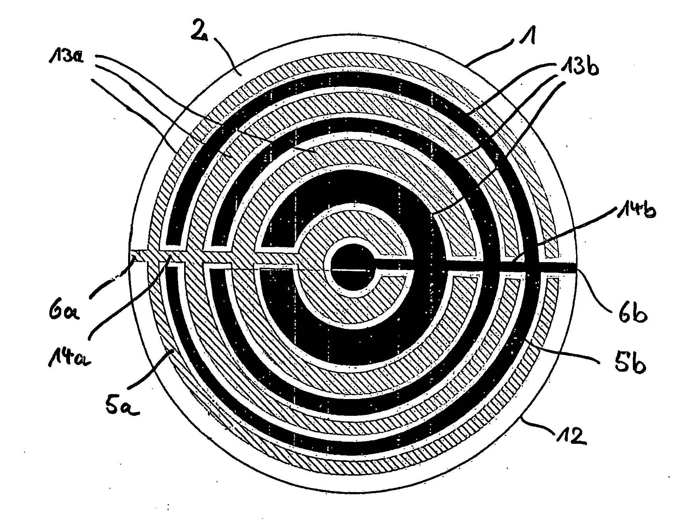

Figur 3 zeigt nun die Aufsicht auf die Vorderseite eines weiteren Trägerwafers 1, bei dem die zu den Leiterbereichen 5a bzw. 5b gehörenden elektrisch leitenden Bereiche 13a, 14a bzw. 13b, 14b als ringförmige Anordnung ausgestaltet sind. Die Leiterbereiche 13a bzw. 13b sind ringförmig und an einer Stelle längs des Umfangs des Trägerwafers 1 durch radiale elektrisch leitende Bereiche 14a bzw. 14b elektrisch leitend miteinander verbunden. Die radialen elektrisch leitenden Bereiche 14a und 14b sind diametral zueinander auf dem Trägerwafer 1 angeordnet und erstrecken sich an diametral zueinander liegenden Stellen bis zur Kante 12 des Wafers 1. An diesen jeweiligen Stellen sind sie jeweils durch Leiterbahnen 6a bzw. 6b über die Kante 12 auf die Rückseite des Trägerwafers 1 durchkontaktiert.

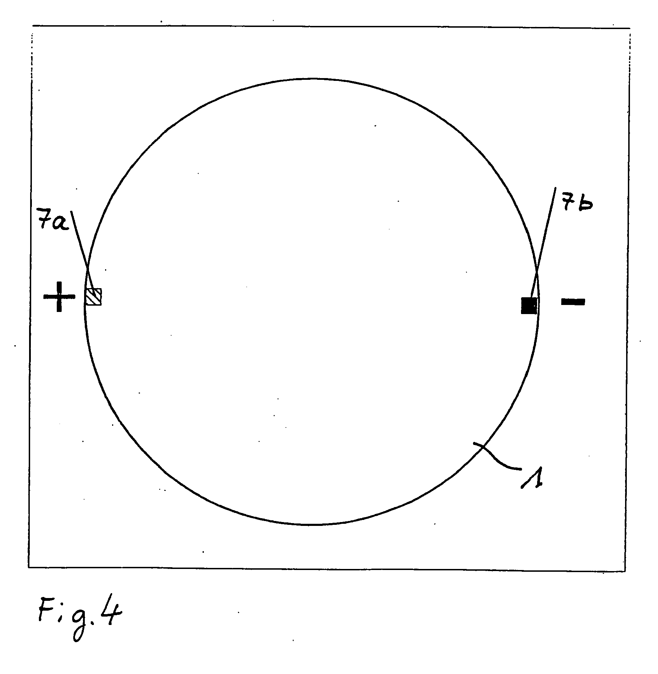

Figur 4 zeigt die Rückseite des in Figur 3 dargestellten Trägerwafers 1. Mit dem Bezugszeichen 7a bzw. 7b sind die mit den Leiterbahnen 6a und 6b auf der Vorderseite und der Kante des Trägerwafers 1 elektrisch leitend verbundenen Kontakte zum Anlegen einer Spannung an die ringförmigen Bereiche 13a, 14a, 13b und 14b bezeichnet. Der Kontakt 7a bildet dabei den Pluspol, während der Kontakt 7b den Minuspol bilden soll.

Durch den in den Figuren 3 und 4 dargestellten Trägerwafer können ebenfalls ultradünne Nutzwafer gehalten werden. Es ist auch möglich, einzelne Chips als Halbleiterbauteile festzuhalten.

Im Falle der Figur 1 hat der Trägerwafer 1 den gleichen nominellen Durchmesser (Ausdehnung a in Längsrichtung) wie der Nutzwafer 15. Der Nutzwafer 15 ist demnach ebenfalls als sehr flacher Zylinder ausgestaltet. Der Trägerwafer 1 erfüllt darüberhinaus dieselben Toleranzanforderungen wie sie an den Nutzwafer 15 gestellt werden. Im vorliegenden Fall eines sogenannten 6-Zoll-Wafers beträgt der Durchmesser 150 mm, die Toleranz für diese Größe a beträgt +/-0,2 mm. Um Probleme mit dem scharfkantigen Rand des ultradünnen Nutzwafers 15 zu vermeiden, ist jedoch der Nutzwafer 15 in diesem Beispiel geringfügig (wenige mm) im Durchmesser kleiner als der Trägerwafer 1. Um in einer Bearbeitungsmaschine, wie beispielsweise einem Plasmaätzer, das ungewollte Anätzen oder in einem Plasmaabscheider das ungewollte Beschichten des Trägerwafers 1 zu vermeiden, kann es sinnvoll sein, den Trägerwafer 1 bzw. die Trägerschicht 2 geringfügig (also wenige mm) kleiner im Durchmesser als den Nutzwafer 15 zu gestalten. Hierdurch wird der Trägerwafer 1 durch Abschattung des Plasmas geschützt. Der Trägerwafer 1 kann somit im Durchmesser auch geringfügig kleiner sein, als standardmäßig in der Halbleitertechnologie übliche Wafer (siehe nachfolgend aufgeführte Tabelle).

Der Trägerwafer 1 wird mit einer solchen Dicke D hergestellt, dass die Summe D+d+i der Dicken D der Trägerschicht 2, der elektrisch leitenden Schicht 4, i der elektrisch isolierenden Schichten 3 und 8 und d des dünnen Nutzwafers 15 innerhalb der Dickentoleranz für Wafer dieses Durchmessers liegt. Mit anderen Worten weist die Gesamtdicke der Waferanordnung einen Wert auf, welcher einem Dickenwert entspricht, wie er üblicherweise von standardmäßigen Handhabungsvorrichtungen der Halbleiterindustrie gehandhabt werden kann. Bei einem Durchmesser von a = 150 mm liegt diese Gesamtdicke meist im Bereich von 655 bis 695 µm. Somit erscheint die Kombination aus Trägerwafer 1 und Nutzwafer 15 für ein Bearbeitungsgerät als normal dick. Bequemerweise wird als Trägerwafer 1 ein standardmäßig dicker Wafer benutzt und lediglich durch Auswahl der Charge die Erfüllung der Dickentoleranz gewährleistet. Für höhere Anforderungen kann der Trägerwafer 1 jedoch auch so auf die notwendige Dicke gebracht werden, indem ein Wafer um die Dicke des Nutzwafers 15 abgedünnt wird.

Selbstverständlich kann die Waferanordnung jedoch auch andere Durchmesser und Gesamtdicken aufweisen. Die in der Halbleitertechnologie üblichen Wafer sind 2-, 3-, 4-, 5-, 6-, 8- und 12-Zoll-Wafer. Die für diese Wafer gemäß dem SEMI-Standard M1-0302 und M1.1 bis M1.15 für den Durchmesser a und die Gesamtdicke D+i+d geltenden Toleranzwerte lassen sich der nachfolgenden Tabelle entnehmen. Die Waferanordnung kann somit ebenfalls die in der Tabelle angegebenen Durchmesser a und Dicken D+d+i mit den jeweils angegebenen Toleranzwerten aufweisen.

| **Durchmesser a** | **Toleranz von a** | **Dicke D+i+d** | **Toleranz von D+i+d** |
|---|---|---|---|
| 50,8 mm | ± 0,38 mm | 279 µm | ± 25 µm |
| 76,2 mm | ± 0,63 mm | 381 µm | ± 25 µm |
| 100 mm | ± 0,5 mm | 525 µm | ± 20 µm |
| 125 mm | ± 0,5 mm | 625 µm | ± 20 µm |
| 150 mm | ± 0,2 mm | 675 µm | ± 20 µm |
| 200 mm | ± 0,2 mm | 725 µm | ± 20 µm |
| 300 mm | ± 0,2 mm | 775 µm | ± 20 µm |

Als Trägerwafer 15 wird hier ein Siliziumwafer in seiner unveränderten Form einer einstückigen, durchgehenden Platte ohne eingebrachte Bohrungen, Kanäle o.ä. verwendet.

Im Falle der Figuren 2 und 3 kann die elektrisch isolierende Schicht zwischen der Trägerschicht und der elektrisch leitenden Schicht entfallen, wenn als Trägerschicht 2 bereits ein elektrisch isolierendes Material verwendet wird.

Die vorliegende Erfindung stellt also einen mobilen, bipolaren elektrostatischen Trägerwafer zur Verfügung, mit dem Halbleiterbauteile, wie beispielsweise ultradünne Wafer oder auch einzelne Chips gehalten und damit in Geräten der Halbleiterindustrie bearbeitet, transportiert und gelagert werden können. Durch Anlegen einer Spannung an die elektrisch leitende Schicht des Trägerwafers wird ein bipolares elektrostatisches Feld zwischen den gegenpoligen Elektroden auf der Vorderseite des Trägerwafers aufgebaut, welches das Halbleiterbauteil sicher hält. Dieser Sandwich aus Träger und Halbleiterbauteil, insbesondere aus Trägerwafer und Nutzwafer, kann dann wie ein normal dicker Wafer in Geräten bearbeitet, von Händlern transportiert und in Waferhorden gelagert werden.

## Patentansprüche

1. Trägerwafer (1) zur Halterung eines scheibenförmigen Halbleiterbauteils, der eine Dicke D aufweist, die innerhalb des für Wafer mit einem Durchmesser
vorgeschriebenen Dickentoleranzbereichs liegt,
mit einer ersten Oberfläche (2a) als Vorderseite und einer der ersten Oberfläche (2a) gegenüberliegenden zweiten Oberfläche (2b) als Rückseite,
und wobei der Trägerwafer weiter aufweist:
a) eine Trägerschicht (2) mit einer die Trägerschicht umgebenden, zweiten elektrisch isolierenden Hüllschicht (3),
oder
eine Trägerschicht (2) aus elektrisch isolierendem Material
b) eine elektrisch leitfähige Schicht (4), die auf der zweiten Hüllschicht (3), oder auf der Trägerschicht (2) aus elektrisch isolierendem Material angeordnet ist und die in mindestens zwei elektrisch voneinander getrennten Bereichen strukturiert ist, wobei jeder der Bereiche auf der Vorderseite des Trägerwafers eine Elektrode (5a,5b) und auf der Rückseite des Trägerwafers einen mit der Elektrode (7a,7b) elektrisch leitend verbundenen elektrischen Kontakt aufweist, sowie
c) eine erste elektrisch isolierende Hüllschicht (8), die auf der elektrisch leitfähigen Schicht (4) angeordnet ist und zumindest die Vorderseite sowie den Rand des Trägerwafers zwischen der Vorderseite und der Rückseite bedeckt,
und wobei
mindestens einer der Bereiche der elektrisch leitfähigen Schicht (4) einen Leitungsabschnitt aufweist, der sich von der Vorderseite des Trägerwafers um den den Gesamtdurchmesser der Trägerschicht (2) begrenzenden Außenrand der Trägerschicht (2) auf die Rückseite des Trägerwafers erstreckt und die Elektrode und den elektrischen Kontakt des Bereiches elektrisch leitend verbindet.

2. Trägerwafer nach dem vorhergehenden Anspruch,
***dadurch gekennzeichnet, dass***
die erste elektrisch isolierende Hüllschicht die Trägerschicht vollständig umgibt mit Ausnahme der elektrischen Kontakte.

3. Trägerwafer nach einem der vorhergehenden Ansprüche, **dadurch gekennzeichnet, dass** die Trägerschicht mindestens eine Durchkontaktierung aufweist, die die Elektrode und den Kontakt jeweils eines der Bereiche der elektrisch leitenden Schicht elektrisch leitend miteinander verbindet.

4. Trägerwafer nach einem der vorhergehenden Ansprüche, **dadurch gekennzeichnet, dass** die elektrisch leitfähige Schicht aus einem Metall, einer Metalllegierung, einem Metallsilizid und/oder geeignet dotiertem Material besteht oder dieses enthält.

5. Trägerwafer nach dem vorhergehenden Anspruch,
***dadurch gekennzeichnet, dass***
die elektrisch leitfähige Schicht aus einem n-dotierten oder p-dotierten Halbleitermaterial besteht oder dieses enthält.

6. Trägerwafer nach dem vorhergehenden Anspruch,
**dadurch gekennzeichnet, dass** die elektrisch leitfähige Schicht aus dotiertem einkristallinem, polykristallinem und/oder amorphem Silizium besteht.

7. Trägerwafer nach einem der beiden vorhergehenden Ansprüche,
***dadurch gekennzeichnet, dass***
die Dotierstoffkonzentration des Halbleiters über 10¹⁴ Atome/cm³ und/oder unter 10²² Atome/cm³, bevorzugt über 10¹⁵ Atome/cm³ und/oder unter 10²¹ Atome/cm³ beträgt und/oder dass als Dotierstoff B, P und/oder As eingesetzt ist.

8. Trägerwafer nach Anspruch 5, **dadurch gekennzeichnet, dass** die elektrisch leitfähige Schicht aus Wolfram, Titan und/oder Titannitrid besteht oder diese enthält.

9. Trägerwafer nach einem der vorhergehenden Ansprüche, **dadurch gekennzeichnet, dass** die Elektroden als Interdigitalelektroden, als Kreissegmente und/oder konzentrische Ringe oder Ringabschnitte ausgebildet sind.

10. Trägerwafer nach einem der vorhergehenden Ansprüche,
***dadurch gekennzeichnet, dass***
das Material der Trägerschicht Si, einen III-V Halbleiter, AlGaAsP, Ge, GaAs, SiC, InP und/oder InGaAs enthält oder daraus besteht.

11. Trägerwafer nach einem der vorhergehenden Ansprüche,
***dadurch gekennzeichnet, dass***
mindestens eine der elektrisch isolierenden Hüllschichten (3) Siliziumdioxid, insbesondere in thermischer aufgewachsener Form oder in mittels CVD-Verfahren abgeschiedener Form, und/oder Siliziumnitrid, Titandioxid und/oder einen organischen oder anorganischen Lack aufweist.

12. Trägerwafer nach einem der vorhergehenden Ansprüche,
***dadurch gekennzeichnet, dass***
mindestens eine der elektrisch isolierenden Hüllschichten (3) zumindest bereichsweise eine Dicke i von über 0.1 µm und/oder von unter 5 µm, insbesondere von 1 µm aufweist.

13. Trägerwafer nach einem der vorhergehenden Ansprüche,
***dadurch gekennzeichnet, dass***
der Durchmesser a des Trägerwafers (2) 50.8 mm ± 0.38 mm, 76.2 mm ± 0.63 mm, 100 mm ± 0.5 mm, 125 mm ± 0.5 mm, 150 mm ± 0.2 mm, 200 mm ± 0.2 mm oder 300 mm ± 0.2 mm beträgt.

14. Anordnung zur Halterung eines scheibenförmigen Halbleiterbauteils mit einem Trägerwafer nach einem der vorhergehenden Ansprüche sowie dem scheibenförmigen Halbleiterbauteil (1), welches ein halbleitendes Material enthält oder daraus besteht.

15. Anordnung nach dem vorhergehenden Anspruch, **dadurch gekennzeichnet, dass** das scheibenförmige Halbleiterbauteil ein zu bearbeitender Nutzwafer, ein Halbleiterbauelement oder ein Chip ist.

16. Anordnung nach einem der beiden vorhergehenden Ansprüche, **dadurch gekennzeichnet, dass** das scheibenförmige Halbleiterbauteil ein zu bearbeitender Nutzwafer ist und die Dimension, Durchmesser und/oder Dicke der Anordnung aus Trägerwafer und Nutzwafer innerhalb der spezifizierten Dimension, Durchmesser und/oder Dicke eines handelsüblichen Wafers liegt.

17. Anordnung nach Anspruch 16,
***dadurch gekennzeichnet, dass***
Trägerschicht (2) und Nutzwafer (1) dasselbe halbleitende Material aufweisen.

18. Anordnung nach einem der Ansprüche 16 oder 17,
***dadurch gekennzeichnet, dass***
das Material des Nutzwafers Si, einen III-V Halbleiter, AlGaAsP, Ge, GaAs, SiC, InP und/oder InGaAs enthält oder daraus besteht.

19. Anordnung nach einem der Ansprüche 16 bis 18,
***dadurch gekennzeichnet, dass***
die Summe der Dicke D des Trägerwafers (2) und der Dicke d des Nutzwafers (1) innerhalb des für Wafer mit einem Durchmesser entsprechend demjenigen des Trägerwafers (2) vorgeschriebenen Dickentoleranzbereichs liegt.

20. Anordnung nach einem der Ansprüche 16 bis 18,
***dadurch gekennzeichnet, dass***
der Durchmesser a des Trägerwafers (2) und/oder des Nutzwafers (1) 150 mm ± 0.2 mm und die Gesamtdicke *D+i+d* des Trägerwafers (2) und des Nutzwafers (1) über 655 µm und/oder unter 695 µm, insbesondere 675 µm, beträgt.

21. Anordnung nach einem der Ansprüche 16 bis 18,
***dadurch gekennzeichnet, dass***
der Durchmesser a des Trägerwafers (2) und/oder des Nutzwafers (1) 50.8 mm ± 0.38 mm und die Gesamtdicke *D+i+d* des Trägerwafers (2) und des Nutzwafers über 254 µm und/oder unter 304 µm, insbesondere 279 µm, beträgt.

22. Anordnung nach einem der Ansprüche 16 bis 18,
***dadurch gekennzeichnet, dass***
der Durchmesser a des Trägerwafers (2) und/oder des Nutzwafers (1) 76.2 mm ± 0.63 mm und die Gesamtdicke *D+i+d* des Trägerwafers (2) und des Nutzwafers über 356 µm und/oder unter 406 µm, insbesondere 381 µm, beträgt.

23. Anordnung nach einem der Ansprüche 16 bis 18,
***dadurch gekennzeichnet, dass***
der Durchmesser a des Trägerwafers (2) und/oder des Nutzwafers (1) 100 mm ± 0.5 mm und die Gesamtdicke *D+i+d* des Trägerwafers (2) und des Nutzwafers (1) über 505 µm und/oder unter 545 µm, insbesondere 525 µm, beträgt.

24. Anordnung nach einem der Ansprüche 16 bis 18,
***dadurch gekennzeichnet, dass***
der Durchmesser a des Trägerwafers (2) und/oder des Nutzwafers (1) 125 mm ± 0.5 mm und die Gesamtdicke *D+i+d* des Trägerwafers (2) und des Nutzwafers (1) über 605 µm und/oder unter 645 µm, insbesondere 625 µm, beträgt.

25. Anordnung nach einem der Ansprüche 16 bis 18,
***dadurch gekennzeichnet, dass***
der Durchmesser a des Trägerwafers (2) und/oder des Nutzwafers (1) 200 mm ± 0.2 mm und die Gesamtdicke *D+i+d* des Trägerwafers (2) und des Nutzwafers (1) über 705 µm und/oder unter 745 µm, insbesondere 725 µm, beträgt.

26. Anordnung nach einem der Ansprüche 16 bis 18,
***dadurch gekennzeichnet, dass***
der Durchmesser a des Trägerwafers (2) und/oder des Nutzwafers (1) 300 mm ± 0.2 mm und die Gesamtdicke *D+i+d* des Trägerwafers (2) und des Nutzwafers (1) über 750 µm und/oder unter 800 µm, insbesondere 775 µm, beträgt.

27. Anordnung nach einem der Ansprüche 16 bis 18,
***dadurch gekennzeichnet, dass***
der mittlere Durchmesser a des Trägerwafers (2) um weniger als 10 %, insbesondere um weniger als 5 %, insbesondere um weniger als 2 %, insbesondere um weniger als 1 %, insbesondere um weniger als 0.5 % größer ist als der mittlere Durchmesser des Nutzwafers (1), wobei bevorzugt beide mittleren Durchmesser übereinstimmen.

28. Anordnung nach einem der Ansprüche 16 bis 18,
***dadurch gekennzeichnet, dass***
der mittlere Durchmesser a des Trägerwafers (2) um weniger als 10 %, insbesondere um weniger als 5 %, insbesondere um weniger als 2 %, insbesondere um weniger als 1 %, insbesondere um weniger als 0.5 % kleiner ist als der mittlere Durchmesser des Nutzwafers (1), wobei bevorzugt beide mittleren Durchmesser übereinstimmen.

29. Anordnung nach einem der Ansprüche 16 bis 18,
***dadurch gekennzeichnet, dass***
die Waferanordnung eine ebene, flache Platte ausbildet, deren Durchmesser a in der Ebene der ersten Oberfläche (2a) wesentlich größer ist als deren Ausdehnung senkrecht zur ersten Oberfläche bzw. als deren Dicke *d+i+D*.

30. Anordnung nach einem der Ansprüche 16 bis 18,
***dadurch gekennzeichnet, dass***
die Anordnung einen flachen Zylinder ausbildet, dessen Zylinderdeckelflächen durch die zweite Oberfläche (2b) und die vom Trägerwafer abgewandt angeordnete Oberfläche des Nutzwafers (1) ausgebildet sind.

31. Anordnung nach dem vorhergehenden Anspruch,
***dadurch gekennzeichnet, dass***
die zylinderförmige Anordnung in der Zylindermantelfläche eine Einkerbung bzw. einen Notch (5) oder eine Abplattung in Form eines geraden Kreisabschnitts bzw. Flats (4) aufweist zur Kennzeichnung der Kristallorientierung.

32. Anordnung nach einem der Ansprüche 16 bis 18,
***dadurch gekennzeichnet, dass***
der Wärmeausdehnungskoeffizient des Materials der Trägerschicht des Trägerwafers vom Wärmeausdehnungskoeffizienten des Materials des Nutzwafers um weniger als 20%, bevorzugt um weniger als 10%, bevorzugt um weniger als 5%, bevorzugt um weniger als 2%, bevorzugt um weniger als 1% abweicht, wobei besonders bevorzugt die beiden Wärmeausdehnungskoeffizienten übereinstimmen.

33. Anordnung nach einem der Ansprüche 16 bis 18,
***dadurch gekennzeichnet, dass***
der Nutzwafer (1) eine Dicke d von über 0.5 µm und/oder unter 200 µm, insbesondere von über 1 µm und/oder unter 100 µm, insbesondere von über 5 und/oder unter 50 µm aufweist.

34. Anordnung nach einem der Ansprüche 14 bis 33,
***dadurch gekennzeichnet, dass***
das Halbleiterbauteil (1) an dem Trägerwafer elektrostatisch fixiert ist.

35. Elektrostatisches Halteverfahren zum Halten eines ein halbleitendes Material aufweisenden scheibenförmigen Bauteils (1),
wobei eine Anordnung nach einem der Ansprüche 14 bis 34 erzeugt wird, indem auf der Oberfläche eines Trägerwafers nach einem der Ansprüche 1 bis 13 das scheibenförmige Bauteil (1) angeordnet wird und zumindest vorübergehend eine elektrische Spannung an die elektrischen Kontakte des Trägerwafers angelegt wird.

36. Halteverfahren nach dem vorhergehenden Anspruch,
***dadurch gekennzeichnet, dass***
eines der beiden Potenziale der elektrischen Spannung dem Erdpotential entspricht.

37. Halteverfahren nach einem der beiden vorhergehenden Ansprüche,
***dadurch gekennzeichnet, dass***
eines der beiden Potenziale der elektrischen Spannung einen Absolutwert von über 20 V und/oder unter 1000 V, insbesondere von über 50 V und/oder unter 500 V aufweist.

38. Halteverfahren nach einem der Ansprüche 36 bis 37,
***dadurch gekennzeichnet, dass***
zeitlich beabstandet mehrfach eine Spannung an die elektrischen Kontakte angelegt wird.

39. Halteverfahren nach einem der Ansprüche 36 bis 38, **dadurch gekennzeichnet, dass** das Bauteil von dem Trägerwafer wieder gelöst wird, indem die Kontakte der beiden Bereich kurzgeschlossen werden, die Kontakte umgepolt werden und/oder an die Kontakte eine vorbestimmte Wechselspannung angelegt wird.

## Claims

1. Carrier wafer (1) for mounting a disc-shaped semiconductor component, having a thickness D, which is within the prescribed thickness tolerance range for wafers with a diameter,
with a first surface (2a) as front-side and a second surface (2b) as rear-side which is situated opposite the first surface (2a),
and wherein the carrier wafer further comprises:
a) a carrier layer (2) with a second electrically insulating cover layer (3) which surrounds the carrier layer,
or
a carrier layer (2) made of an electrically insulating material
b) an electrically conductive layer (4) which is disposed on the second cover layer (3) or on the carrier layer (2) made of an electrically insulating material and which is structured in at least two regions which are separated from each other electrically, each of the regions having, on the front-side of the carrier wafer, an electrode (5a, 5b) and, on the rear-side of the carrier wafer, an electrical contact which is connected to the electrode (7a, 7b) in an electrically conductive manner, and also
c) a first electrically insulating cover layer (8) which is disposed on the electrically conductive layer (4) and covers at least the front-side and also the edge of the carrier wafer between the front-side and the rear-side,
and wherein
at least one of the regions of the electrically conductive layer (4) has a conductor section which extends from the front-side of the carrier wafer around the outer edge of the carrier layer (2) delimiting the entire diameter of the carrier layer (2) to the rear-side of the carrier wafer and connects the electrode and the electrical contact of the region in an electrically conductive manner.

2. Carrier wafer according to the preceding claim,
***characterized in that***
the first electrically insulating cover layer surrounds the carrier layer completely with the exception of the electrical contacts.

3. Carrier wafer according to one of the preceding claims,
***characterized in that***
the carrier layer has at least one through-contacting which connects together the electrode and the contact respectively of one of the regions of the electrically conductive layer in an electrically conductive manner.

4. Carrier wafer according to one of the preceding claims,
***characterized in that***
the electrically conductive layer consists of or contains a metal, a metal alloy, a metal silicide and/or suitably doped material.

5. Carrier wafer according to the preceding claim,
***characterized in that***
the electrically conductive layer consists of or contains an n-doped or p-doped semiconductor material.

6. Carrier wafer according to the preceding claim,
***characterized in that***
the electrically conductive layer consists of doped monocrystalline, polycrystalline and/or amorphous silicon.

7. Carrier wafer according to one of the two preceding claims,
***characterized in that***
the doping agent concentration of the semiconductor is above 10¹⁴ atoms/cm³ and/or below 10²² atoms/cm³, preferably above 10¹⁵ atoms/cm³ and/or below 10²¹ atoms/cm³ and/or **in that** B, P and/or As is used as doping agent.

8. Carrier wafer according to claim 6,
***characterized in that***
the electrically conductive layer consists of or contains tungsten, titanium and/or titanium nitride.

9. Carrier wafer according to one of the preceding claims, **characterized in that** the electrodes are configured as interdigital electrodes, as circle segments and/or concentric rings or ring portions.

10. Carrier wafer according to one of the preceding claims,
***characterized in that***
the material of the carrier layer contains or consists of Si, a III-V semiconductor, AlGaAsP, Ge, GaAs, SiC, InP and/or InGaAs.

11. Carrier wafer according to one of the preceding claims,
***characterized in that***
at least one of the electrically insulating cover layers (3) comprises silicon dioxide, in particular in a thermal grown form or in a form deposited by means of CVD methods, and/or silicon nitride, titanium dioxide and/or an organic or inorganic varnish.

12. Carrier wafer according to one of the preceding claims,
***characterized in that***
at least one of the electrically insulating cover layers (3) has, at least in regions, a thickness i of above 0.1 µm and/or of below 5 µm, in particular of 1 µm.

13. Carrier wafer according to one of the preceding claims,
***characterized in that***
the diameter a of the carrier wafer (2) is 50.8 mm ± 0.38 mm, 76.2 mm ± 0.63 mm, 100 mm ± 0.5 mm, 125 mm ± 0.5 mm, 150 mm ± 0.2 mm, 200 mm ± 0.2 mm or 300 mm ± 0.2 mm.

14. Arrangement for mounting a disc-shaped semiconductor component having a carrier wafer according to one of the preceding claims and also the disc-shaped semiconductor component (1) which contains or consists of a semiconductive material.

15. Arrangement according to the preceding claim, **characterized in that** the disc-shaped semiconductor component is a usable wafer to be machined, a semiconductor component or a chip.

16. Arrangement according to one of the two preceding claims, **characterized in that** the disc-shaped semiconductor component is a usable wafer to be machined and the dimension, diameter and/or thickness of the arrangement comprising carrier wafer and usable wafer is within the specified dimension, diameter and/or thickness of a commercially available wafer.

17. Arrangement according to claim 16,
***characterized in that***
carrier layer (2) and usable wafer (1) comprise the same semiconductive material.

18. Arrangement according to one of the claims 16 or 17,
***characterized in that***
the material of the usable wafer contains or consists of Si, a III-V semiconductor, AlGaAsP, Ge, GaAs, SiC, InP and/or InGaAs .

19. Arrangement according to one of the claims 16 to 18,
***characterized in that***
the sum of the thickness D of the carrier wafer (2) and the thickness d of the usable wafer (1) is within the prescribed thickness tolerance range for wafers with a diameter corresponding to that of the carrier wafer (2).

20. Arrangement according to one of the claims 16 to 18,
***characterized in that***
the diameter a of the carrier wafer (2) and/or of the usable wafer (1) is 150 mm ± 0.2 mm and the total thickness *D+i+d* of the carrier wafer (2) and of the usable wafer (1) is above 655 µm and/or below 695 µm, in particular 675 µm.

21. Arrangement according to one of the claims 16 to 18,
***characterized in that***
the diameter a of the carrier wafer (2) and/or of the usable wafer (1) is 50.8 mm ± 0.38 mm and the total thickness *D+i+d* of the carrier wafer (2) and the usable wafer is above 254 µm and/or below 304 µm, in particular 279 µm.

22. Arrangement according to one of the claims 16 to 18,
***characterized in that***
the diameter a of the carrier wafer (2) and/or of the usable wafer (1) is 76.2 mm ± 0.63 mm and the total thickness *D+i+d* of the carrier wafer (2) and the usable wafer is above 356 µm and/or below 406 µm, in particular 381 µm.

23. Arrangement according to one of the claims 16 to 18,
***characterized in that***
the diameter a of the carrier wafer (2) and/or of the usable wafer (1) is 100 mm ± 0.5 mm and the total thickness *D+i+d* of the carrier wafer (2) and the usable wafer (1) is above 505 µm and/or below 545 µm, in particular 525 µm.

24. Arrangement according to one of the claims 16 to 18,
***characterized in that***
the diameter a of the carrier wafer (2) and/or of the usable wafer (1) is 125 mm ± 0.5 mm and the total thickness *D+i+d* of the carrier wafer (2) and the usable wafer (1) is above 605 µm and/or below 645 µm, in particular 625 µm.

25. Arrangement according to one of the claims 16 to 18,
***characterized in that***
the diameter a of the carrier wafer (2) and/or of the usable wafer (1) is 200 mm ± 0.2 mm and the total thickness *D+i+d* of the carrier wafer (2) and the usable wafer (1) is above 705 µm and/or below 745 µm, in particular 725 µm.

26. Arrangement according to one of the claims 16 to 18,
***characterized in that***
the diameter a of the carrier wafer (2) and/or of the usable wafer (1) is 300 mm ± 0.2 mm and the total thickness *D+i+d* of the carrier wafer (2) and the usable wafer (1) is above 750 µm and/or below 800 µm, in particular 775 µm.

27. Arrangement according to one of the claims 16 to 18,
***characterized in that***
the average diameter a of the carrier wafer (2) is greater by less than 10%, in particular by less than 5%, in particular by less than 2%, in particular by less than 1%, in particular by less than 0.5% than the average diameter of the usable wafer (1), preferably both average diameters agreeing.

28. Arrangement according to one of the claims 16 to 18,
***characterized in that***
the average diameter a of the carrier wafer (2) is smaller by less than 10%, in particular by less than 5%, in particular by less than 2%, in particular by less than 1%, in particular by less than 0.5% than the average diameter of the usable wafer (1), preferably both average diameters agreeing.

29. Arrangement according to one of the claims 16 to 18,
***characterized in that***
the wafer arrangement forms a level, flat plate, the diameter a of which in the plane of the first surface (2a) is substantially greater than the extension thereof perpendicular to the first surface or than the thickness *d+i+D* thereof.

30. Arrangement according to one of the claims 16 to 18,
***characterized in that***
the arrangement forms a flat cylinder, the cylinder cover faces of which are configured by the second surface (2b) and the surface of the usable wafer (1) which is disposed orientated away from the carrier wafer.

31. Arrangement according to the preceding claim,
***characterized in that***
the cylindrical arrangement in the cylinder outer peripheral face has a notch (5) or a flattening in the form of a straight circle portion or flat (4) for characterising the orientation of the crystals.

32. Arrangement according to one of the claims 16 to 18,
***characterized in that***
the heat expansion coefficient of the material of the carrier layer of the carrier wafer deviates from the heat expansion coefficient of the material of the usable wafer by less than 20%, preferably by less than 10%, preferably by less than 5%, preferably by less than 2%, preferably by less than 1%, the heat expansion coefficients agreeing in a particularly preferred manner.

33. Arrangement according to one of the claims 16 to 18,
***characterized in that***
the usable wafer (1) has a thickness d of above 0.5 µm and/or below 200 µm, in particular of above 1 µm and/or below 100 µm, in particular of above 5 and/or below 50 µm.

34. Arrangement according to one of the claims 14 to 33,
***characterized in that***
the semiconductor component (1) is fixed electrostatically to the carrier wafer.

35. Electrostatic retaining method for retaining a disc-shaped component (1) which comprises a semiconductive material,
an arrangement according to one of the claims 14 to 34 being produced in that the disc-shaped component (1) is disposed on the surface of a carrier wafer according to one of the claims 1 to 13 and an electrical voltage is applied to the electrical contacts at least temporarily.

36. Retaining method according to the preceding claim,
***characterized in that***
one of the two potentials of the electrical voltage corresponds to earth potential.

37. Retaining method according to one of the two preceding claims,
***characterized in that***
one of the two potentials of the electrical voltage has an absolute value of above 20 V and/or below 1000 V, in particular of above 50 V and/or below 500 V.

38. Retaining method according to one of the claims 36 to 37,
***characterized in that***
a voltage is applied to the electrical contacts several times at a temporal interval.

39. Retaining method according to one of the claims 36 to 38,
***characterized in that***
the component is detached again from the carrier wafer by the contacts of the two regions being short-circuited, the contacts having the polarity reversed and/or a predetermined alternating voltage being applied to the contacts.

## Revendications

1. Plaquette de support (1) pour maintenir un composant semi-conducteur en forme de disque, qui présente une épaisseur *D*, qui se situe dans la plage de tolérance d'épaisseur prescrite pour une plaquette avec diamètre,
avec une première surface (2a) comme face avant et une seconde surface (2b) opposée à la première surface (2a) comme face arrière,
et dans laquelle la plaquette de support présente en outre :
a) une couche de support (2) avec une seconde couche enveloppante (3) électriquement isolante, entourant la couche de support,
ou
une couche de support (2) constituée d'un matériau électriquement isolant,
b) une couche électroconductrice (4) qui est agencée sur la seconde couche enveloppante (3) ou sur la couche de support (2) constituée d'un matériau électriquement isolant et qui est structurée en au moins deux zones séparées électriquement l'une de l'autre, dans laquelle chacune des zones sur la face avant de la plaquette de support présente une électrode (5a, 5b) et, sur la face arrière de la plaquette de support, un contact électrique connecté par voie électroconductrice à l'électrode (7a, 7b), ainsi que
c) une première couche enveloppante (8) électriquement isolante qui est agencée sur la couche électroconductrice (4) et qui recouvre au moins la face avant, ainsi que le bord de la plaquette de support entre la face avant et la face arrière,
et dans laquelle
au moins l'une des zones de la couche électroconductrice (4) présente une section de conduction, qui s'étend depuis la face avant de la plaquette de support autour du bord externe de la couche de support (2), délimitant le diamètre total de la couche de support (2), sur la face arrière de la plaquette de support et connecte par voie électroconductrice l'électrode et le contact électrique de la zone.

2. Plaquette de support selon la revendication précédente,
**caractérisée en ce que**
la première couche enveloppante électriquement isolante entoure complètement la couche de support, à l'exception des contacts électriques.

3. Plaquette de support selon l'une quelconque des revendications précédentes,
**caractérisée en ce que**
la couche de support présente au moins une métallisation transversale qui connecte l'un à l'autre par voie électroconductrice l'électrode et le contact, respectivement, d'une des zones de la couche électroconductrice.

4. Plaquette de support selon l'une quelconque des revendications précédentes,
**caractérisée en ce que**
la couche électroconductrice est constituée d'un métal, d'un alliage métallique, d'un siliciure de métal et/ou d'un matériau dopé de manière appropriée ou en contient.

5. Plaquette de support selon la revendication précédente,
**caractérisée en ce que**
la couche électroconductrice est constituée d'un matériau semi-conducteur dopé n ou dopé p ou en contient.

6. Plaquette de support selon la revendication précédente,
**caractérisée en ce que**
la couche électroconductrice est constituée de silicium dopé monocristallin, polycristallin et/ou amorphe.

7. Plaquette de support selon l'une quelconque des deux revendications précédentes,
**caractérisée en ce que**
la concentration en substance de dopage du semi-conducteur est supérieure à 10¹⁴ atomes/cm³ et/ou inférieure à 10²² atomes/cm³, de préférence supérieure à 10¹⁵ atomes/cm³ et/ou inférieure à 10²¹ atomes/cm³ et/ou **en ce que** B, P et/ou As est/sont utilisé(s) en tant que substance de dopage.

8. Plaquette de support selon la revendication 5,
**caractérisée en ce que**
la couche électroconductrice est constituée de tungstène, de titane et/ou de nitrure de titane ou en contient.

9. Plaquette de support selon l'une quelconque des revendications précédentes,
**caractérisée en ce que**
les électrodes se présentent sous la forme d'électrodes interdigitales, de segments circulaires et/ou d'anneaux concentriques ou de sections annulaires.

10. Plaquette de support selon l'une quelconque des revendications précédentes,
**caractérisée en ce que**
le matériau de la couche de support contient l'élément Si, un semi-conducteur de type III-V, les composés AlGaAsP, Ge, GaAs, SiC, InP et/ou InGaAs ou en est constitué.

11. Plaquette de support selon l'une quelconque des revendications précédentes,
**caractérisée en ce que**
au moins l'une des couches enveloppantes (3) électriquement isolantes comporte du dioxyde de silicium, en particulier sous une forme obtenue par croissance thermique ou sous une forme isolée par un procédé CVD, et/ou du nitrure de silicium, du dioxyde de titane et/ou un vernis organique ou inorganique.

12. Plaquette de support selon l'une quelconque des revendications précédentes,
**caractérisée en ce que**
au moins l'une des couches enveloppantes (3) électriquement isolantes présente au moins par segment une épaisseur *i* supérieure à 0,1 µm et/ou inférieure à 5 µm, en particulier de 1 µm.

13. Plaquette de support selon l'une quelconque des revendications précédentes,
**caractérisée en ce que**
le diamètre a de la plaquette de support (2) est de 50,8 mm ± 0,38 mm, de 76,2 mm ± 0,63 mm, de 100 mm ± 0,5 mm, de 125 mm ± 0,5 mm, de 150 mm ± 0,2 mm, de 200 mm ± 0,2 mm ou de 300 mm ± 0,2 mm.

14. Aménagement pour maintenir un composant semi-conducteur en forme de disque avec une plaquette de support selon l'une quelconque des revendications précédentes, ainsi que le composé semi-conducteur (1) en forme de disque, qui contient un matériau semi-conducteur ou qui en est constitué.

15. Aménagement selon la revendication précédente,
**caractérisé en ce que**
le composant semi-conducteur en forme de disque est une plaquette d'utilisation à usiner, un composant semi-conducteur ou une puce.

16. Aménagement selon l'une quelconque des deux revendications précédentes,
**caractérisé en ce que**
le composant semi-conducteur en forme de disque est une plaquette d'utilisation à usiner et **en ce que** la dimension, le diamètre et/ou l'épaisseur de l'aménagement constitué de la plaquette de support et de la plaquette d'utilisation respectent la dimension, le diamètre et/ou l'épaisseur spécifié(s) pour une plaquette usuelle.

17. Aménagement selon la revendication 16,
**caractérisé en ce que**
la couche de support (2) et la plaquette d'utilisation (1) comportent le même matériau semi-conducteur.

18. Aménagement selon l'une quelconque des revendications 16 ou 17,
**caractérisé en ce que**
le matériau de la plaquette d'utilisation contient l'élément Si, un semi-conducteur de type III-V, les composés AlGaAsP, Ge, GaAs, SiC, InP et/ou InGaAs ou en est constitué.

19. Aménagement selon l'une quelconque des revendications 16 à 18,
**caractérisé en ce que**
la somme de l'épaisseur *D* de la plaquette de support (2) et de l'épaisseur *d* de la plaquette d'utilisation (1) se situe dans la plage de tolérance d'épaisseur prescrite pour une plaquette avec un diamètre correspondant à celui de la plaquette de support (2).

20. Aménagement selon l'une quelconque des revendications 16 à 18,
**caractérisé en ce que**
le diamètre *a* de la plaquette de support (2) et/ou de la plaquette d'utilisation (1) est de 150 mm ± 0,2 mm et l'épaisseur totale *D+i+d* de la plaquette de support (2) et de la plaquette d'utilisation (1) est supérieure à 655 µm et/ou inférieure à 695 µm, en particulier de 675 µm.

21. Aménagement selon l'une quelconque des revendications 16 à 18,
**caractérisé en ce que**
le diamètre *a* de la plaquette de support (2) et/ou de la plaquette d'utilisation (1) est de 50,8 mm ± 0,38 mm et l'épaisseur totale *D+i+d* de la plaquette de support (2) et de la plaquette d'utilisation est supérieure à 254 µm et/ou inférieure à 304 µm, en particulier de 279 µm.

22. Aménagement selon l'une quelconque des revendications 16 à 18,
**caractérisé en ce que**
le diamètre *a* de la plaquette de support (2) et/ou de la plaquette d'utilisation (1) est de 76,2 mm ± 0,63 mm et l'épaisseur totale *D+i+d* de la plaquette de support (2) et de la plaquette d'utilisation est supérieure à 356 µm et/ou inférieure à 406 µm, en particulier de 381 µm.

23. Aménagement selon l'une quelconque des revendications 16 à 18,
**caractérisé en ce que**
le diamètre *a* de la plaquette de support (2) et/ou de la plaquette d'utilisation (1) est de 100 mm ± 0,5 mm et l'épaisseur totale *D+i+d* de la plaquette de support (2) et de la plaquette d'utilisation (1) est supérieure à 505 µm et/ou inférieure à 545 µm, en particulier de 525 µm.

24. Aménagement selon l'une quelconque des revendications 16 à 18,
**caractérisé en ce que**
le diamètre a de la plaquette de support (2) et/ou de la plaquette d'utilisation (1) est de 125 mm ± 0,5 mm et l'épaisseur totale *D+i+d* de la plaquette de support (2) et de la plaquette d'utilisation (1) est supérieure à 605 µm et/ou inférieure à 645 µm, en particulier de 625 µm.

25. Aménagement selon l'une quelconque des revendications 16 à 18,
**caractérisé en ce que**
le diamètre *a* de la plaquette de support (2) et/ou de la plaquette d'utilisation (1) est de 200 mm ± 0,2 mm et l'épaisseur totale *D+i+d* de la plaquette de support (2) et de la plaquette d'utilisation (1) est supérieure à 705 µm et/ou inférieure à 745 µm, en particulier de 725 µm.

26. Aménagement selon l'une quelconque des revendications 16 à 18,
**caractérisé en ce que**
le diamètre *a* de la plaquette de support (2) et/ou de la plaquette d'utilisation (1) est de 300 mm ± 0,2 mm et l'épaisseur totale *D+i+d* de la plaquette de support (2) et de la plaquette d'utilisation (1) est supérieure à 750 µm et/ou inférieure à 800 µm, en particulier de 775 µm.

27. Aménagement selon l'une quelconque des revendications 16 à 18,
**caractérisé en ce que**
le diamètre moyen *a* de la plaquette de support (2) est supérieur d'une valeur inférieure à 10 %, en particulier d'une valeur inférieure à 5 %, en particulier d'une valeur inférieure à 2 %, en particulier d'une valeur inférieure à 1 %, en particulier d'une valeur inférieure à 0,5 % au diamètre moyen de la plaquette d'utilisation (1), les deux diamètres moyens coïncidant de préférence.

28. Aménagement selon l'une quelconque des revendications 16 à 18,
**caractérisé en ce que**
le diamètre moyen *a* de la plaquette de support (2) est inférieur d'une valeur inférieure à 10 %, en particulier d'une valeur inférieure à 5 %, en particulier d'une valeur inférieure à 2 %, en particulier d'une valeur inférieure à 1 %, en particulier d'une valeur inférieure à 0,5 % au diamètre moyen de la plaquette d'utilisation (1), les deux diamètres moyens coïncidant de préférence.

29. Aménagement selon l'une quelconque des revendications 16 à 18, **caractérisé en ce que**
l'aménagement de la plaquette forme une plaque plate plane, dont le diamètre a dans le plan de la première surface (2a) est sensiblement supérieur à son extension perpendiculairement à la première surface respectivement à son épaisseur *d*+*i*+*D*.

30. Aménagement selon l'une quelconque des revendications 16 à 18,
**caractérisé en ce que**
l'aménagement forme un cylindre plat, dont les surfaces de couvercle sont formées par la seconde surface (2b) et la surface de la plaquette d'utilisation (1) aménagée à l'opposé de la plaquette de support.

31. Aménagement selon la revendication précédente,
**caractérisé en ce que**
l'aménagement cylindrique dans la surface de paroi de cylindre présente une entaille respectivement une encoche (5), ou un aplatissement sous la forme d'une section circulaire droite respectivement d'un méplat (4), pour identifier l'orientation cristalline.

32. Aménagement selon l'une quelconque des revendications 16 à 18,
**caractérisé en ce que**
le coefficient de dilatation thermique du matériau de la couche de support de la plaquette de support diverge du coefficient de dilatation thermique du matériau de la plaquette d'utilisation de moins de 20 %, de préférence de moins de 10 %, de préférence de moins de 5 %, de préférence de moins de 2 %, de préférence de moins de 1 %, les deux coefficients de dilatation thermique coïncidant de forte préférence.

33. Aménagement selon l'une quelconque des revendications 16 à 18,
**caractérisé en ce que**
la plaquette d'utilisation (1) présente une épaisseur d supérieure à 0,5 µm et/ou inférieure à 200 µm, en particulier supérieure à 1 µm et/ou inférieure à 100 µm, en particulier supérieure à 5 et/ou inférieure à 50 µm.

34. Aménagement selon l'une quelconque des revendications 14 à 33,
**caractérisé en ce que**
le composant semi-conducteur (1) est fixé à la plaquette de support par voie électrostatique.

35. Procédé de maintien électrostatique pour maintenir un composant (1) en forme de disque présentant un matériau semi-conducteur,
dans lequel un aménagement selon l'une quelconque des revendications 14 à 34 est produit en aménageant le composant (1) en forme de disque sur la surface d'une plaquette de support selon l'une quelconque des revendications 1 à 13 et en appliquant au moins temporairement une tension électrique aux contacts électriques de la plaquette de support.

36. Procédé de maintien selon la revendication précédente,
**caractérisé en ce que**
l'un des deux potentiels de la tension électrique correspond au potentiel de terre.

37. Procédé de maintien selon l'une quelconque des deux revendications précédentes,
**caractérisé en ce que**
l'un des deux potentiels de la tension électrique présente une valeur absolue supérieure à 20 V et/ou inférieure à 1000 V, en particulier supérieure à 50 V et/ou inférieure à 500 V.

38. Procédé de maintien selon l'une quelconque des revendications 36 à 37,
**caractérisé en ce que**
on applique, à intervalles de temps, de multiples fois une tension aux contacts électriques.

39. Procédé de maintien selon l'une quelconque des revendications 36 à 38,
**caractérisé en ce que**
le composant est à nouveau détaché de la plaquette de support en court-circuitant les contacts des deux zones, en inversant les contacts et/ou en appliquant une tension alternative prédéterminée aux contacts.
